# EUROPEAN PATENT SPECIFICATION

(11) **EP 2 824 978 B1**
(45) Date of publication and mention of the grant of the patent: **05.09.2018**
(21) Application number: 13176401.1
(22) Date of filing: 12.07.2013
(51) Int. Cl.: H03F 1/02, H04W 52/52, H04W 52/08

(54) **System and method for controlling envelope tracking in a transmitter with closed loop power control**
System und Verfahren zur Steuerung der Hüllkurvenverfolgung in einem Sender mit geschlossener Leistungsregelung
Système et procédé de commande de suivi d'enveloppe dans un émetteur avec commande de puissance en boucle fermée

(43) Date of publication of application: 14.01.2015
(73) Proprietor: BlackBerry Limited, Waterloo, ON N2K 0A7 (CA)
(72) Inventor: Devison, Stephen, Arnold, Waterloo, Ontario N2L 3W8 (CA); Snyder, Christopher, Eugene, Waterloo, Ontario N2L 3W8 (CA)
(74) Representative: MERH-IP Matias Erny Reichl Hoffmann Patentanwälte PartG mbB

(56) References cited:
- GB-A- 2 488 119
- US-A1- 2011 058 601

## Description

### TECHNICAL FIELD

Example embodiments relate to controlling envelope tracking in a transmitter with closed loop power control, and more particularly to coordinating automatic power control and signal envelope tracking in a transmitter.

### BACKGROUND

Radio-frequency (RF) mobile communication devices typically employ power saving techniques to increase battery life. Because the transmitter power amplifier of a mobile communication device consumes a large percentage of the overall power utilized by the device, various power management systems are used to increase the overall power efficiency of the power amplifier.

One such system adjusts the transmission power of a mobile communication device in order to utilize the least amount of power necessary to maintain signal quality while minimizing interference between different wireless networks within range of the device. The use of closed automatic power control (APC) loops may be used to control power changes from one desired power level to another within the transmitter of the mobile communication device. For example, in response to receipt of a command from a cellular base station to reduce transmission power, it is known in the art to employ an APC loop between a transmitter output stage and a power amplifier of the transmitter for controlling gain and bias settings of the transmitter output stage.

Envelope tracking (ET) is another power management system known in the art, for adjusting the power supply voltage applied to the power amplifier so that the amplifier operates at peak efficiency for given instantaneous output power requirements. In operation, the voltage supplied to the power amplifier is synchronized with the envelope of the RF signal passing through the transmitter, thereby reducing unused energy that would otherwise be dissipated as heat.

In conventional envelope tracking (ET) transmitters, the gain applied to the ET signal path is scaled in response to a power step (e.g. using a table lookup) and applied to an ET modulator immediately before closing the APC loop. However, step-wise gain adjustment (scaling) of the ET signal path can result in spectral anomalies before the APC loop is closed, which persist until the APC loop has stabilized.

US 2011/0058601 A1 disclsoes an apparatus and method for amplifying a Transmit (Tx) signal according to an Envelope Tacking (ET) scheme in a wireless communication system. A transmitting end apparatus includes an envelope gain controller for controlling a gain of a digital baseband Tx signal in accordance with power control, a detector for detecting an envelope signal from the digital baseband Tx signal whose gain is controlled, and for shaping on the envelope signal, a first Digital to Analog Converter (DAC) for converting the shaped envelope signal into an analog signal, and an envelope modulator for generating a drain bias of a power amplifier that amplifies a Radio Frequency (RF) Tx signal by using the analog envelope signal.

### SUMMARY

In accordance with an example embodiment, there is provided a transmitter for a mobile communication device, comprising: a processor for generating a baseband signal and a control signal; a transmit signal path having a modulator for up-converting the baseband signal to an RF signal, and a transmit output stage for pre-amplifying the RF signal; a power amplifier for amplifying the pre-amplified RF signal; an antenna for transmitting the amplified RF signal; an envelope tracking signal path having a function block for converting the envelope of the baseband signal into a shaped envelope signal; wherein said function block includes a lookup table containing pre-calculated envelope shape values; an automatic power control loop for receiving the control signal from the processor and for receiving a feedback signal tapped from the output of the power amplifier and in response generating a corrective signal for controlling the gain of the transmit output stage and the shape of the envelope signal from the envelope tracking signal path; and an envelope tracking modulator for receiving the envelope signal and synchronizing power applied to the power amplifier therewith; wherein said function block is configured to execute a calibration routine that uses the corrective signal from the automatic power control loop to address the lookup table containing the envelope shape values.

According to a further aspect, there is provided a method for controlling envelope tracking in a transmitter with closed loop power control, comprising up-converting and pre-amplifying a baseband signal to a pre-amplified RF signal; amplifying the pre-amplified RF signal at a power amplifier; converting the envelope of the baseband signal into a shaped envelope signal; receiving a feedback signal tapped from an output of the power amplifier; based on a control signal and the feedback signal generating a corrective signal; using the corrective signal for adjusting the gain of the pre-amplified RF signal and the shape of the envelope signal; wherein the step of converting the envelope of the baseband signal into a shaped envelope signal includes executing a calibration routine that uses the gain of the pre-amplified RF signal to address a lookup table containing pre-calculated envelope shape values.

### BRIEF DESCRIPTION OF THE DRAWINGS

FIG. 1 is an illustration of a block diagram of a prior art transmitter incorporating automatic power control and signal envelope tracking.
FIG. 2 is an illustration of a block diagram of a transmitter incorporating automatic power control and signal envelope tracking in accordance with an example embodiment; and
FIG. 3 illustrates a flow chart depicting a method for coordinating automatic power control and signal envelope tracking in accordance with the example embodiment of FIG. 2.
Reference will now be made to the exemplary embodiments illustrated, and specific language will be used herein to describe the same. It will nevertheless be understood that no limitation of the scope of protection is thereby intended.

### DETAILED DESCRIPTION OF EXAMPLE EMBODIMENTS

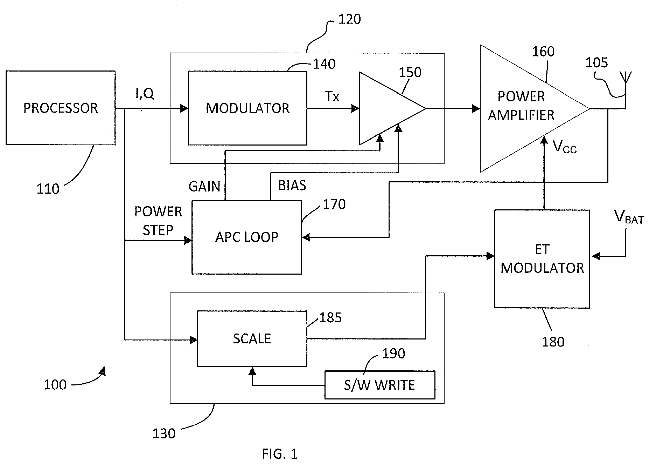

With reference to FIG. 1, a prior art transmitter 100 is shown that can, in some embodiments, form the transmit portion of a communication subsystem of a mobile communication device (not shown). Such a communication subsystem may also include a receive portion for receiving electromagnetic signals.

A data signal that is to be transmitted using the transmitter 100 is typically a comparatively low frequency signal that is generally referred to as a baseband signal. The baseband signal is mixed with a carrier signal having a substantially higher frequency, as discussed below, to produce a transmission signal. The transmission signal is then amplified and radiated by an antenna 105. The amplified transmission signal is preferably sufficiently amplified so that it is received with little or no data loss at a remote base station or another communication device

Transmitter 100 includes a processor 110, that acts as a controller for a transmit path 120 and envelope tracking (ET) path 130. For example, the gains applied to communication signals in transmitter 100 may be adaptively controlled using automatic power control (APC) algorithms and envelope tracking algorithms implemented in the processor 110, as described in greater detail below.

Transmit path 120 includes a modulator 140 and a transmit output stage 150. Processor 110 also provides the in-phase and quadrature baseband signal (I, Q) to modulator 140. Although not shown, and as would be understood by a person of skill in the art, modulator 140 typically includes a pair modulator stages that are driven by a local oscillator that generates a high-frequency carrier signal, for frequency up-converting the baseband signal (I, Q) to a transmission signal (Tx).

The transmit output stage 150 functions as a variable gain amplifier and typically has a broad power range. The transmit output stage 150 received the up-converted transmission signal (Tx) and produces a pre-amplified transmission signal to a power amplifier 160 whose output is connected to antenna 105. The gain of the output stage is varied to provide an amount of gain dependent upon the desired power level for the amplified transmission signal. The gain of the transmit output stage 150 is dictated by an automatic power control loop, APC 170, as discussed in greater detail below. The power amplifier 160 amplifies the pre-amplified transmission signal to provide the remainder of the required gain, and passes the amplified radio frequency (RF) signal to antenna 105.

The antenna 105 may be embedded or internal to the mobile communication device, and formed of at least some conductive material for receiving or transmitting (or both) of electromagnetic signals.

The power amplifier 160 can provide a substantial gain, but typically has a smaller power gain than transmit output stage 150. It will be understood to a person skilled in the art that the power amplifier 160 may include one or multiple amplification stages.

In operation, in response to receiving a power step command (i.e. a control signal from processor 110 indicating a desired change in power setting (typically in steps of 1 dB - 30 dB), APC loop 170 continuously adjusts the gain and/or bias of the analog transmit output stage 150 so as to smoothly transition between power levels. Typically, the APC 170 loop includes a power controller that is driven by a reference signal, and a feedback signal tapped (usually via a power coupling device) from the output of power amplifier 160. One example of such a power controller is a proportional-integral-derivative (PID) controller. The feedback signal from the power amplifier 160 is compared to the reference signal in the power controller, which then attempts to minimize the error in the loop by applying a corrective signal (gain, bias) to the analog transmit output stage 150 in the feed-forward transmit path 120. Depending on the range of the gain setting, a new bias range can be selected in order to reduce current.

The envelope tracking (ET) path 130 can be used to convert envelope or amplitude data associated with the baseband (I, Q) signal into shaped envelope data for application to an ET modulator 180. Shaping the envelope data from the baseband processor 110 can aid in enhancing performance of the power amplifier system 160 by, for example, adjusting the envelope signal to optimize linearity of the power amplifier 160 and/or to achieve a desired gain compression of the power amplifier 160. In certain implementations, the ET path 130 comprises a digital block having a digital scale function 185 and software write 190 to convert shaped envelope data into an analog envelope signal suitable for use by the ET modulator 180.

The ET modulator 180 receives the envelope signal from the ET path 130 and a battery voltage V_{BAT}, and uses the envelope signal to generate a power amplifier supply voltage V_{CC} for the power amplifier 160 that changes in relation to the envelope. The power amplifier 160 receives the RF signal from the transmit path 120, and provides an amplified RF signal to the antenna 105, as discussed above.

It is desirable that the gain of the envelope tracking (ET) path 130 track gain changes in the transmit path 120 in order to maintain output signal quality. However, in the prior art transmitter of FIG. 1, operation of the transmit path 120 and ET path 130 are independent. Thus, in the event of a power step, (i.e. a change in required power output of the transmitter 100), the baseband signal (I, Q) in the ET path 130 undergoes static gain adjustment via operation of the digital scale function 185 and software write 190 before the APC loop 170 closes (i.e. stabilizes to the new power setting). Thus, when changing the gain in the transmit path 120 between two power levels, stepping the gain in the ET path 130 can lead to undesired compression and power discontinuities of the transmitted output signal during the transition between the two power levels, resulting in undesired spectral distortion of the radiated signal until the APC loop 170 is closed.

More specifically, between the time that the software write 190 begins scaling down the ET gain and the time that the APC loop 170 closes (stabilizes), the spectrum of the radiated signal is subjected to uncontrollable distortion.

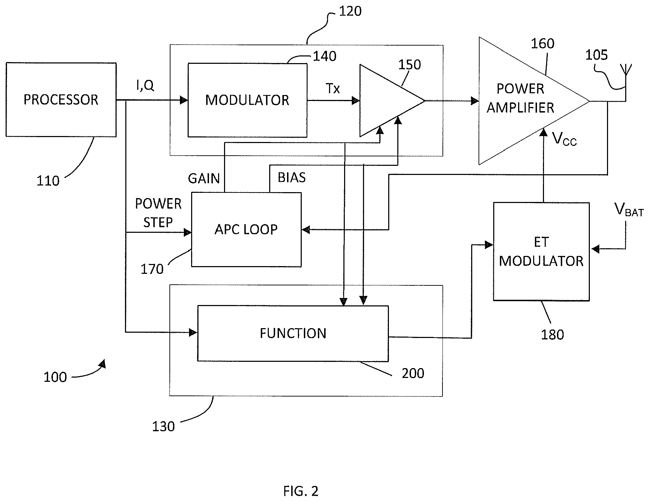

FIG. 2 shows a transmitter incorporating automatic power control and signal envelope tracking in accordance with an example embodiment, wherein like reference numerals denote like elements of the transmitter illustrated in FIG. 1.

However, in the embodiment of FIG. 2, gain scaling in the ET path 130 is guided by the APC loop 170, via the gain and bias signal outputs of the APC loop 170, which are then conditioned by a function block 200. The function block 200 includes a multiplier and a look up table (LUT) for calibrating the shape of the envelope tracking response. In one embodiment, block 200 may be implemented using circuitry that approximates an arbitrary function F(x), as described in commonly assigned United States Patent Application No. 13/525506, filed on June 18, 2012. The LUT implemented within block 200 stores values representing the desired shape of the envelope control signal addressed using a combination of the actual baseband signal (I. Q) and the gain and bias signals received from the APC loop 170. The output from the LUT is then applied to the ET modulator 180 for adjusting the power amplifier supply voltage V_{CC} for the power amplifier 160, as discussed above.

In one embodiment, the LUT may contain pre-calculated envelope shape values (i.e. a static table) that are addressed using the received gain and bias signal values. In other embodiments, function block 200 may execute a calibration routine that receives the gain and bias signals from the APC loop 170 and uses those signals to address the envelope tracking LUT. Also, the values stored in the LUT may represent either straight-line scaling of the envelope (i.e. upward scaling by increasing the slope of the line and downward scaling by decreasing the slope), or may represent a complex shape of the envelope through the use of higher order polynomials.

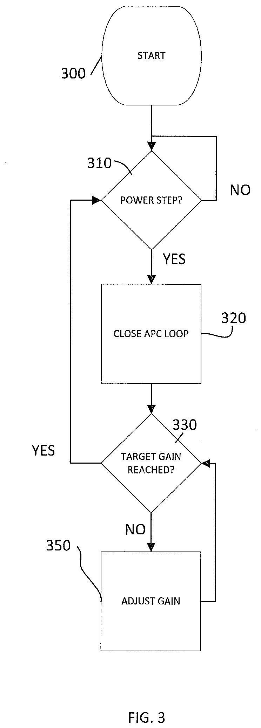

FIG. 3 is a flowchart depicting a method for coordinating automatic power control and signal envelope tracking in accordance with the example embodiment of FIG. 2. The method begins at step 300 and enters a wait state for receipt of a power step command from processor 110. Upon receipt of a power step command (a YES at step 310), the APC loop 170 is immediately closed (step 320). Upon closing the APC loop 170 the internal power controller is activated for tracking the power step and applying error correction (gain, bias) to the transmit path 120. This ensures that the output of power amplifier 160 accurately tracks the desired power step. Following activation of the APC loop 170 (i.e. closing the loop), the power amplifier output will track to the target output power, being guided by the APC loop 170, and stabilize once the loop settles.

A determination is made at step 330 as to whether or not the target gain set point for the power step has been reached within the APC path 170. If not (a NO at step 330) the gain is continually adjusted via the APC loop 170 and the determination step 330 is repeated until the target gain has been reached, as discussed above.

Once the target gain has been reached (a YES at step 330), the method returns to a wait state for the next power step command (step 310).

From FIG. 3, it will be appreciated that control signals (gain, bias) from the APC loop 170 effectively guide the ET path gain such that the APC loop simultaneously controls gain setting during the power transition in both the transmit path 120 and the ET path 130.

As discussed above in connection with the prior art, spectral discontinuities occur between the stages of ET scaling/gain change and closing of the APC loop 170. The method of FIG. 3 eliminates interim scaling of the ET path 130, thereby addressing the problem of spectral distortion during power steps.

The various embodiments presented above are merely examples and are in no way meant to limit the scope of this disclosure. Variations of the innovations described herein will be apparent to persons of ordinary skill in the art, such variations being within the intended scope of the present disclosure. In particular, features from one or more of the above-described embodiments may be selected to create alternative embodiments comprised of a sub-combination of features which may not be explicitly described above. In addition, features from one or more of the above-described embodiments may be selected and combined to create alternative embodiments comprised of a combination of features which may not be explicitly described above. Features suitable for such combinations and subcombinations would be readily apparent to persons skilled in the art upon review of the present disclosure as a whole.

## Claims

1. A transmitter (100) for a mobile communication device, comprising:
a processor (110) for generating a baseband signal and a control signal;
a transmit signal path (120) comprising a modulator (140) for up-converting the baseband signal to an RF signal, and a transmit output stage (150) for pre-amplifying the RF signal;
a power amplifier (160) for amplifying the pre-amplified RF signal;
an antenna (105) for transmitting the amplified RF signal;
an envelope tracking signal path (130) comprising a function block (200) for converting the envelope of the baseband signal into a shaped envelope signal, wherein said function block (200) includes a lookup table containing pre-calculated envelope shape values;
an automatic power control loop (170) for
receiving the control signal from the processor,
receiving a feedback signal tapped from an output of the power
amplifier (160), and in response generating a corrective signal for controlling the gain of the pre-amplified RF signal at the transmit output stage (150)
and the shape of the envelope signal from the envelope tracking signal path (130), and
an envelope tracking modulator (180) for receiving the shaped envelope signal and synchronizing power applied to the power amplifier therewith; wherein said function block (200) is configured to execute a calibration routine that uses the corrective signal from the automatic power control loop to address the lookup table containing the envelope shape values.

2. A transmitter as in claim 1, wherein said envelope shape values represent straight-line scaling of the envelope shape wherein upward scaling is **characterized by** increasing the slope of the line and downward scaling is **characterized by** decreasing the slope of the line.

3. A transmitter as in claim 1, wherein said envelope shape values represent a complex envelope shape **characterized by** higher order polynomials.

4. A transmitter as in any of claims 1 to 3, wherein said corrective signal is a gain control signal and/or a bias control signal.

5. A method for controlling envelope tracking in a transmitter (100) with closed loop power control, comprising
a. up-converting and pre-amplifying a baseband signal to a pre-amplified RF signal;
b. amplifying the pre-amplified RF signal at a power amplifier;
c. converting the envelope of the baseband signal into a shaped envelope signal;
d. receiving a feedback signal tapped from an output of the power amplifier;
e. based on a control signal and the feedback signal, generating a corrective signal used to control the gain of the pre-amplified RF signal and a shape of the envelope signal;
wherein the step of converting the envelope of the baseband signal into a shaped envelope signal includes executing a calibration routine that uses the gain of the pre-amplified RF signal to address a lookup table containing pre-calculated envelope shape values.

6. The method of claim 5, wherein said envelope shape values represent straight-line scaling of the envelope shape, wherein upward scaling is **characterized by** increasing the slope of the line and downward scaling is **characterized by** decreasing the slope of the line, or represent a complex envelope shape **characterized by** higher order polynomials.

## Patentansprüche

1. Sender (100) für ein mobiles Kommunikationsgerät, Folgendes umfassend:
einen Prozessor (110) zum Erzeugen eines Basisbandsignals und eines Steuersignals;
einen Sendesignalweg (120), einen Modulator (140) zum Aufwärtswandeln des Basisbandsignals in ein Funksignal und eine Sendeausgangsstufe (150) zum Vorverstärken des Funksignals umfassend;
einen Leistungsverstärker (160) zum Verstärken des vorverstärkten Funksignals;
eine Antenne (105) zum Senden des verstärkten Funksignals;
einen Hüllkurvennachverfolgungs-Signalweg (130), einen Funktionsblock (200) zum Umwandeln der Hüllkurve des Basisbandsignals in ein Signal mit geformter Hüllkurve umfassend, wobei der Funktionsblock (200) eine Nachschlagetabelle beinhaltet, die vorberechnete Hüllkurvenformwerte enthält;
einen automatischen Leistungssteuerkreis (170) zum
Empfangen des Steuersignals vom Prozessor,
Empfangen eines Rückkopplungssignals, das von einem Ausgang des Leistungsverstärkers (160) abgezapft wird, und
in Reaktion Erzeugen eines Korrektursignals zum Steuern der Verstärkung des vorverstärkten Funksignals an der Sendeausgangsstufe (150) und der Form des Hüllkurvensignals vom Hüllkurvennachverfolgungs-Signalweg (130), und
einen Hüllkurvennachverfolgungs-Modulator (180) zum Empfangen des Signals mit geformter Hüllkurve und zum Synchronisieren von Leistung, die damit am Leistungsverstärker anliegt;
wobei der Funktionsblock (200) dafür konfiguriert ist, eine Kalibrierungsroutine auszuführen, die das Korrektursignal von dem automatischen Leistungssteuerkreis verwendet, um die Nachschlagetabelle anzusprechen, welche die Hüllkurvenformwerte enthält.

2. Sender nach Anspruch 1, wobei die Hüllkurvenformwerte eine lineare Skalierung der Hüllkurve darstellen, wobei eine Aufwärtsskalierung durch eine Zunahme der Steigung der Kurve gekennzeichnet ist und eine Abwärtsskalierung durch eine Abnahme der Steigung der Kurve gekennzeichnet ist.

3. Sender nach Anspruch 1, wobei die Hüllkurvenformwerte eine komplexe Hüllkurvenform darstellen, die durch Polynome höherer Ordnung gekennzeichnet ist.

4. Sender nach einem der Ansprüche 1 bis 3, wobei das Korrektursignal ein Verstärkungssteuersignal und/oder ein Vorspannungssteuersignal ist.

5. Verfahren zum Steuern von Hüllkurvennachverfolgung in einem Sender (100) mit geschlossener Leistungssteuerung, Folgendes umfassend:
a. Aufwärtswandeln und Vorverstärken eines Basisbandsignals zu einem vorverstärkten Funksignal;
b. Verstärken des vorverstärkten Funksignals in einem Leistungsverstärker;
c. Umwandeln der Hüllkurve des Basisbandsignals in ein Signal mit geformter Hüllkurve;
d. Empfangen eines Rückkopplungssignals, das von einem Ausgang des Leistungsverstärkers abgezapft wird;
e. Erzeugen eines Korrektursignals, das zum Steuern der Verstärkung des vorverstärkten Funksignals und einer Form des Hüllkurvensignals verwendet wird, basierend auf einem Steuersignal und dem Rückkopplungssignal;
wobei der Schritt des Umwandelns der Hüllkurve des Basisbandsignal in ein Signal mit geformter Hüllkurve das Ausführen einer Kalibrierungsroutine beinhaltet, welche die Verstärkung des vorverstärkten Funksignals verwendet, um die Nachschlagetabelle anzusprechen, die vorberechnete Hüllkurvenformwerte enthält.

6. Verfahren nach Anspruch 5, wobei die Hüllkurvenformwerte lineares Skalieren der Hüllkurve darstellen, wobei eine Aufwärtsskalierung durch eine Zunahme der Steigung der Kurve gekennzeichnet ist und eine Abwärtsskalierung durch eine Abnahme der Steigung der Kurve gekennzeichnet ist, oder eine komplexe Hüllkurvenform darstellen, die durch Polynome höherer Ordnung gekennzeichnet ist.

## Revendications

1. Émetteur (100) pour un dispositif de communication mobile, comprenant :
un processeur (110) pour générer un signal de bande de base et un signal de commande ;
un chemin de signal d'émission (120) comprenant un modulateur (140) pour convertir par élévation de fréquence le signal de bande de base en un signal RF, et un étage de sortie d'émission (150) pour pré-amplifier le signal RF ;
un amplificateur de puissance (160) pour amplifier le signal RF pré-amplifié ;
une antenne (105) pour émettre le signal RF amplifié ;
un chemin de signal de suivi d'enveloppe (130) comprenant un bloc de fonction (200) pour convertir l'enveloppe du signal de bande de base en un signal à enveloppe mis en forme, où ledit bloc de fonction (200) comporte une table de consultation contenant des valeurs de forme d'enveloppe précalculées ;
une boucle de commande de puissance automatique (170) pour
recevoir le signal de commande à partir du processeur,
recevoir un signal de rétroaction prélevé d'une sortie de l'amplificateur de puissance (160), et
en réponse, générer un signal correcteur pour commander le gain du signal RF pré-amplifié au niveau de l'étage de sortie d'émission (150) et la forme du signal à enveloppe provenant du chemin de signal de suivi d'enveloppe (130), et
un modulateur de suivi d'enveloppe (180) pour recevoir le signal à enveloppe mis en forme et synchroniser la puissance appliquée à l'amplificateur de puissance avec celui-ci ;
où ledit bloc de fonction (200) est configuré pour exécuter une routine d'étalonnage qui utilise le signal correcteur provenant de la boucle de commande de puissance automatique pour adresser la table de consultation contenant les valeurs de forme d'enveloppe.

2. Émetteur selon la revendication 1, dans lequel lesdites valeurs de forme d'enveloppe représentent une mise à l'échelle linéaire de la forme d'enveloppe, où la mise à l'échelle ascendante est **caractérisée par** l'augmentation de la pente de la droite et la mise à l'échelle descendante est **caractérisée par** la diminution de la pente de la droite.

3. Émetteur selon la revendication 1, dans lequel lesdites valeurs de forme d'enveloppe représentent une forme d'enveloppe complexe **caractérisée par** des polynômes d'ordre supérieur.

4. Émetteur selon l'une des revendications 1 à 3, dans lequel ledit signal correcteur est un signal de commande de gain et/ou un signal de commande de polarisation.

5. Procédé de commande de suivi d'enveloppe dans un émetteur (100) à commande de puissance en boucle fermée, comprenant le fait
a. de convertir par élévation de fréquence et de pré-amplifier un signal de bande de base en un signal RF pré-amplifié ;
b. d'amplifier le signal RF pré-amplifié au niveau d'un amplificateur de puissance ;
c. de convertir l'enveloppe du signal de bande de base en un signal à enveloppe mis en forme ;
d. de recevoir un signal de rétroaction prélevé d'une sortie de l'amplificateur de puissance ;
e. sur la base d'un signal de commande et du signal de rétroaction, de générer un signal correcteur utilisé pour commander le gain du signal RF pré-amplifié et une forme du signal à enveloppe ;
dans lequel l'étape de conversion de l'enveloppe du signal de bande de base en un signal à enveloppe mis en forme comporte le fait d'exécuter une routine d'étalonnage qui utilise le gain du signal RF pré-amplifié pour adresser une table de consultation contenant des valeurs de forme d'enveloppe précalculées.

6. Procédé de la revendication 5, dans lequel lesdites valeurs de forme d'enveloppe représentent une mise à l'échelle linéaire de la forme d'enveloppe, où la mise à l'échelle ascendante est **caractérisée par** l'augmentation de la pente de la droite et la mise à l'échelle descendante est **caractérisée par** la diminution de la pente de la droite, ou représentent une forme d'enveloppe complexe **caractérisée par** des polynômes d'ordre supérieur.
